# EUROPEAN PATENT SPECIFICATION

(11) **EP 1 511 026 B1**
(45) Date of publication and mention of the grant of the patent: **10.10.2007**
(21) Application number: 04018203.2
(22) Date of filing: 31.07.2004
(51) Int. Cl.: G11B 7/26, G03F 7/038, G03F 7/004

(54) **Method for manufacturing a master of an optical information recording medium, method for forming a pattern, a master, a stamper, an optical information recording medium and a resist**
Verfahren zur Herstellung einer Masterplatte für ein optisches Aufzeichnungsmedium, Verfahren zur Herstellung eines Musters, einer Mutterplatte, einer Matrize, eines optischen Aufzeichnungsmediums und eines Resists
Procédé pour fabriquer un disque maître destiné à la fabrication du support d'enregistrement optique, procédé pour fabriquer un disque mère, une matrice de pressage, un support d'enregistrement optique et une épargne

(30) Priority: 26.08.2003 JP 2003300853
(43) Date of publication of application: 02.03.2005
(73) Proprietor: MATSUSHITA ELECTRIC INDUSTRIAL CO., LTD, Kadoma-shi, Osaka 571-8501 (JP)
(72) Inventor: Ito, Eiichi, Nishinomiya City Hyogo 663-8033 (JP); Ohno, Eiji, Hirakata City Osaka 573-0171 (JP); Kawaguchi, Yuuko, Ibaraki City Osaka 567-0046 (JP)
(74) Representative: Eisenführ, Speiser & Partner

(56) References cited:
- EP-A- 0 423 446
- EP-A- 0 896 974
- US-A- 4 603 101
- US-A- 4 624 912
- US-A- 4 761 464
- US-A1- 2002 142 244
- PATENT ABSTRACTS OF JAPAN vol. 1999, no. 09, 30 July 1999 (1999-07-30) & JP 11 102540 A (PIONEER ELECTRON CORP), 13 April 1999 (1999-04-13)
- PATENT ABSTRACTS OF JAPAN vol. 012, no. 102 (P-684), 5 April 1988 (1988-04-05) & JP 62 234248 A (RICOH CO LTD), 14 October 1987 (1987-10-14)
- PATENT ABSTRACTS OF JAPAN vol. 2003, no. 08, 6 August 2003 (2003-08-06) & JP 2003 123328 A (HITACHI LTD), 25 April 2003 (2003-04-25)

## Description

### BACKGROUND OF THE INVENTION

### 1. Field of the Invention

The present invention relates to a resist that enables heat-mode recording, a method for forming a pattern using the resist, a method for manufacturing an optical information recording medium, a master, a stamper, and an optical information recording medium.

### 2. Description of the Prior Art

A method for forming a pattern uses a photosensitive material that is called a resist, in which the state of the resist changes selectively by means of exposure to light (including various radiation rays such as an electron beam or a charged particle beam). After that, etching (and developing) is performed so as to form a pattern of pits and lands by using different etching rates between portions where the state of the resist is changed and portions where the state is not changed. This method is practically used in various types of micromachining for manufacturing optical information recording media or semiconductor devices.

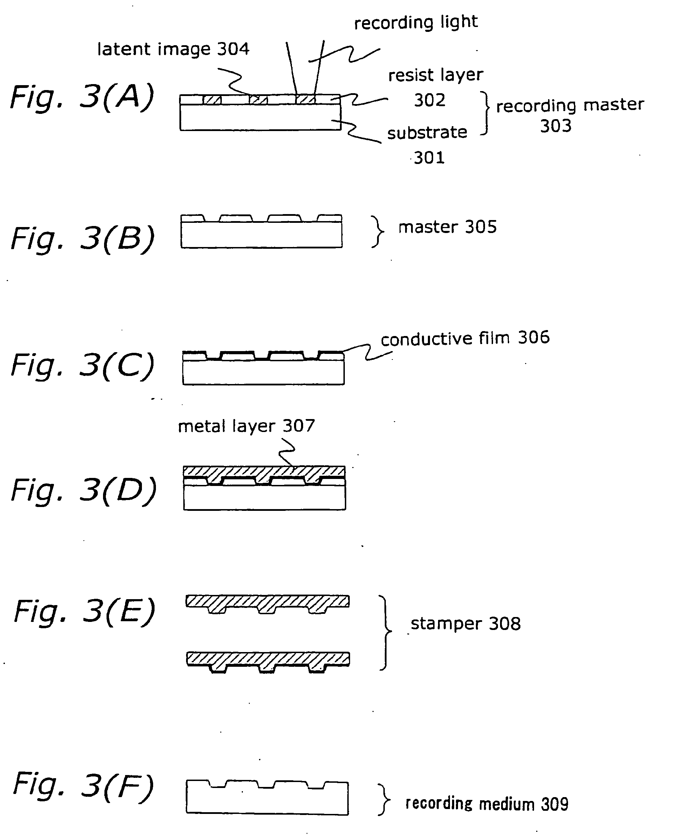

A conventional example of the method for forming a pattern by using the resist will be described with reference to Fig. 3, in which a method for manufacturing optical information recording media is exemplified.

First, a process for manufacturing a master 305 will be described. A recording master 303 that includes a resist layer 302 formed on a substrate 301 is exposed to a laser beam or an electron ray so that a desired pattern such as a guide groove or information pits is formed as a latent image 304 (Fig. 3(A)). The recording master 303 is developed after the exposure, and the desired pattern that is recorded as the latent image 304 becomes lands or pits so that the master 305 is produced (Fig. 3(B)). Here, Fig. 3 shows the case where the latent image is formed as pits. Note that a blue color laser or an ultraviolet ray laser is used widely for the exposure, and an alkali solution is used widely for the development, in the manufacturing process of a master for a DVD or a next generation optical information recording medium.

Next, a manufacturing process of a stamper 308 will be described. A conductive film 306 is formed on the master 305 (Fig. 3(C)), and then a metal layer 307 is formed by plating that utilizes the conductive film 306 (Fig. 3(D)). Then, the metal layer 307 only or the metal layer 307 with the conductive film 306 is removed from the master 305, and a shaping process such as back side polishing or punching is performed on the metal layer 307 so as to make the stamper 308.

Finally, a disk substrate of the optical information recording medium 309 is made by injection molding in which the stamper 308 is used (Fig. 3(F)). A positive type resist has been described above. However the above description will also apply to a negative type resist, except that the pits and lands on the master are reversed (see Fig. 3(E)).

The above description of a method for manufacturing a master of an optical information recording medium is an example of a method of forming a pattern using a resist. This method of forming a pattern is a photon-mode recording method, which uses a resist that is a photosensitive material, and utilizes a photochemical reaction during exposure. However, there is another method in which a heat-sensitive material is used as the resist and heat-mode recording is performed (see Japanese Unexamined Patent Publication No. H10-97738, for example) .

Heat-mode recording is a recording method that utilizes a change of state caused by a change of temperature due to exposure. This method enables the photosensitive change to be made in only a part of the exposed portion where a specific temperature has been reached. Therefore, when using the same wavelength of light for exposure, it is possible to make a minuter pattern than by using photon-mode recording in which a photosensitive change continuously occurs over the entire exposed portion depending on the exposure intensity. In other words, heat-mode recording enables the formation of a minute pattern of pits and lands which is the same size as is conventional, but by using light of a longer wavelength.

Recently, in methods for forming a pattern using a resist, the wavelength of light used for exposure has been becoming shorter, such as 248 nm or 193 nm, in order to produce a minuter pattern. Furthermore, an electron beam may also be used for exposure, and use and manufacture of a resist, a light source, and optical components is becoming more difficult. In this environment, there are demands for a method of forming a pattern using a resist by heat-mode recording in which light of a longer wavelength can be used to form a minute pattern of the same size.

One idea is to use a chalcogen compound, which is a well-known phase change material, as a potential resist that enables heat-mode recording (see Japanese Unexamined Patent Publication No. H10-97738, for example). However, there is no document that clearly describes a specific resist and a method for forming a pattern using a chalcogen compound. The present inventors have noted tellurium oxide, which is a chalcogen compound, and evaluated the characteristics thereof as a resist. As a result, it was found that the material has very low contrast with respect to development, meaning there are substantial practical problems such as the ratio of remaining film and the line edge roughness.

JP 11-102540 discloses a method for manufacturing an optical disc which includes a process, in which a positive-type photoresist layer is formed on the main surface of a glass substrate to form a master disc. A laser beam is focused onto the photoresist layer to form a latent image consisting of fine recesses. The master disc is then brought into contact with an alkali solution to remove the latent image part and developed and fined recesses are formed on the maser disc. The master disc is developed in alkali solution whose normality is within a range of 0.17 N -0.21 N.

EP 0 423 446 A1 discloses a photoacid-generating photoresist composition sensitized with an aromatic-multi-ring, heterocyclic nitrogen containing sensitizer, preferably a ring extended phenothiazine derivative. The use of the sensitizer permits exposure of photoresists to near UV irradiation, where such photoresists have heretofore been exposed to deep UV irradiation.

### SUMMARY OF THE INVENTION

An object of the present invention is to provide a resist that enables heat-mode recording, has high environmental resistance, a wide wavelength range in which the resist can be used, a high ratio of remaining film during development, low line edge roughness, and capable of use in conventional development equipment, as well as a method for forming a pattern using the above resist and a method for manufacturing an optical information recording medium using the resist.

A method for manufacturing a master of an optical information recording medium, a method for forming a pattern, a master itself, a stamper, an optical information recording medium and a resist according to the present invention will be described. The method of manufacturing a master of an optical information recording medium includes a resist layer formation step of using a resist to form a resist layer on an upper surface of a substrate, an exposure step for selectively exposing the resist layer to cause a change of state in the resist layer, and a development step for performing an alkali development process on the resist layer after the exposure step. The resist is primarily composed of an inorganic material which contains at least Te and O, and further contains a stabilizing additive having a lower solubility than TeO₂ in an alkaline environment.

In the method of manufacturing a master of an optical information recording medium according to the present invention, the Te and TeO₂ enables heat-mode recording, is inert toward light of a wide wavelength range such as sunlight, has absorbency in a wide wavelength range from vacuum ultraviolet to infrared, and enables development by alkali. Furthermore, the stabilizing additive improves resistance of unexposed portions to a developing solution, so that good pattern forming can be performed.

The resist preferably contains Te and O in the composition formula TeOₓ, where 0.3 ≦ x ≦ 1.7, and more preferably contains Te and O in the composition formula TeOₓ where 0.8 ≦ x ≦ 1.4.

As the stabilizing additive, the resist preferably contains at least one material selected from the group consisting of Mg, Si, Ti, V, Cr, Mn, Fe, Co, Ni, Cu, As, Se, Y, Nb, Mo, Tc, Ru, Rh, Pd, Ag, Cd, In, Sb, Ta, W, Pt, Au, Bi and a combination of these elements, and more preferably contains at least one material selected from the group consisting of Pd, Au, Pt, Cu, Sb, Bi, Si and a combination of these elements.

The composition ratio of the stabilizing additive in the resist is preferably within the range of 0.05-0.55, and more preferably within the range of 0.15-0.50. This is because the above range enables a sufficiently high ratio of remaining film upon development and a sufficiently low line edge roughness.

In the method of manufacturing an optical information recording medium according to the present invention, in the resist layer formation step the resist layer is preferably formed by a vacuum process. A vacuum evaporation method or a sputtering method can be used as the vacuum process, while the sputtering method is the most preferable method.

In the method of manufacturing a master of an optical information recording medium according to the present invention, in the development step an alkali solution is used as a developing solution. It is preferable to use TMAH as the alkali. This is because residue of the exposed portion is particularly low when TMAH is used. In this case, a concentration of TMAH is preferably within the range 0.02%-20%.

In the method of manufacturing a master of an optical information recording medium according to the present invention, in the exposure step, a wavelength of light that is used for exposure can be any wavelength that can be absorbed by the resist of the present invention, but light having a wavelength at least between 121-940 nm can be used. In addition, the thickness of the resist layer is preferably within the range of 5-200 nm.

According to the present invention, a method of manufacturing a master of an optical information recording medium, a method for forming a pattern, a master itself, a stamper, an optical information recording medium and a resist can be obtained, which: enable heat-mode recording; enable use of conventional development equipment; and have a resist with high environmental resistance, which can absorb a wide wavelength range, has a high ratio of remaining film upon development, and has low line edge roughness.

### BRIEF DESCRIPTION OF THE DRAWINGS

Figs. 1(A) - 1(C) show a method for forming a pattern according to the present invention;
Fig. 2 shows an exposure method in the method for forming a pattern according to the present invention; and
Fig. 3 shows a conventional technique.

### DESCRIPTION OF THE PREFERRED EMBODIMENTS

Hereinafter, embodiments of the present invention will be described with reference to the attached drawings.

A method for manufacturing a master of an optical information recording medium will be used as an example of the resist and the method for forming a pattern according to the present invention. However, the effects of the resist and the method for forming a pattern of the present invention are not limited to this application. Of course, the effects of the present invention can be obtained not only in the recording of a master of an optical information recording medium, but also in the manufacture of semiconductor devices and in various photolithography techniques.

### (1) Resist layer formation step

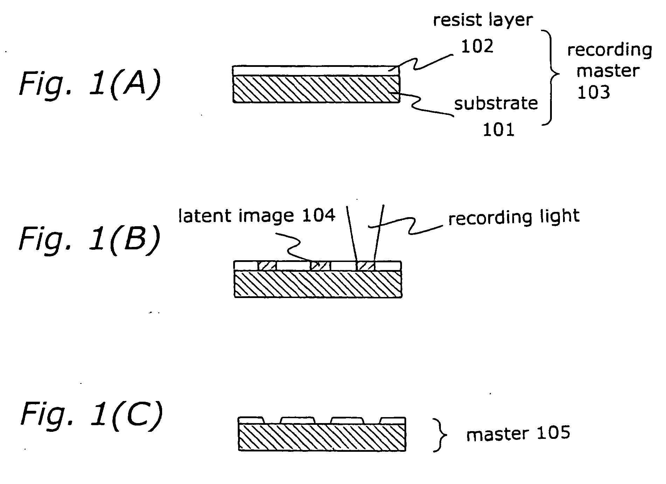

As shown in Fig. 1(A) in cross section, a resist layer 102 is formed on a substrate 101 made of any type of glass, silicon or a resin, and is referred to as a recording master 103. The resist layer 102 is made primarily of a resist composed of an inorganic material, and the resist contains at least Te, O (hereinafter the combination of Te and O is referred to as TeOₓ), and a stabilizing additive which is a material having a lower solubility than TeO₂ in an alkaline environment. The resist layer 102 is formed by a vacuum process such as a sputtering method or a vacuum evaporation method. Note that the recording master may include other elements such as an interface layer, a thermal insulating layer or a reflection layer, as long as it maintains the structure described above.

The substrate can be provided with a pattern of pits and lands in advance so as to be used for manufacturing a semiconductor device, or may be any material other than that described above, so long as it does not prevent the resist layer from being formed as described below in detail.

When using a sputtering method to form the resist layer, a target having the same composition as the desired resist may be used so as to perform sputtering in an inert gas such as Ar or Xe, or a target of TeOₓ and a target of the stabilizing additive may be prepared individually so as to perform cosputtering. Furthermore, regarding the TeOₓ target, a target (that can be a single Te target) having a lower ratio of O than the resist may be used by mixing O into the inert gas (such as Ar or Xe) so as to perform reactive sputtering, for example. Similarly, in the case where a vacuum evaporation method is used, the vapor deposition may be performed from a single material or a plurality of materials. When performing the method of the present invention, a sputtering method (especially a reactive sputtering method for fine adjustment of quantity of O) is preferable for forming a resist layer, because a uniform amorphous film can be formed easily, fine adjustment of the composition (especially quantity) will be easy, little dust is generated, and a stable film can be formed. However, the effects of the present invention can be obtained by any method that can produce the resist of the present invention, such as by sintering powder material. Note that the composition of the resist and its characteristics will be described later in detail.

### (2) Exposure step

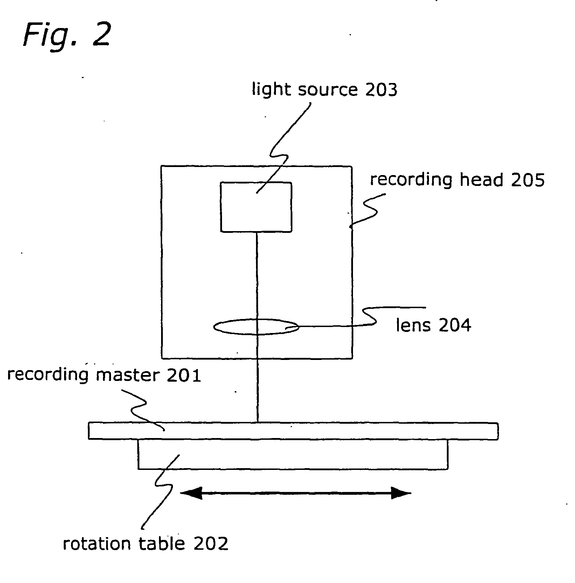

Next, as shown in Fig. 1(B), a latent image 104 is recorded by selectively exposing the recording master 103, which will be described in detail with reference to Fig. 2. A recording master 201 is placed on a rotation table 202 and is rotated with the rotation table 202. Recording light emitted by a light source 203 is focused by a lens 204 onto a surface of the recording master 201. If necessary, the recording light may be modulated and deflected in the recording light source 203. During the recording process, a recording head 205 and the rotation table 202 are moved relative to each other and in parallel, so that a spiral-like recording is performed on the recording master. The recording light can be any light that can selectively raise the temperature of the resist layer, although a laser beam or an electron beam is also suitable for the method of the present invention, because of its focusing properties and availability of abundant peripheral components.

Note that, though a method for recording a master of an optical information recording medium was described above as an example of the exposure step in the method of the present invention, any other method such as photolithography that can raise temperature of the resist by selective exposure can be used as the method of the present invention.

### (3) Development step

Next, the recording master is developed by using an alkali solution such as tetramethyl ammonium hydroxide (TMAH), KOH or NaOH. A conventional development method such as a spray method, a shower method or a puddle method can be used for the development, and thus conventional equipment can be used. Note that so long as the development method uses an alkali, the effect of the present invention is gained. As shown in Fig. 1(C), a master 105 on which the latent image 104 is formed as a pit pattern can be manufactured by means of the development.

### (Embodiment 1)

The resist of the present invention works as a positive type resist by means of the alkali development process. A mechanism thereof will be described, and details of its composition will be described with reference to experimental results. The material TeOₓ is well known as a phase change material and is commercialized in a write-once, read-many type optical di s k, for example. The present inventors discovered the phenomenon that alkali solubility of TeOₓ is increased by crystallization due to exposure and a mechanism thereof. The present inventors also found that the alkali solubility of unexposed portions (uncrystallized portions) is lowered when a stabilizing additive is added that is a material having a lower solubility than TeO₂ in an alkaline environment, and that the ratio of remaining film and the line edge roughness are improved. This mechanism is thought to be as follows.

The material TeOₓ in the resist of the present invention is in an amorphous state before the exposure, that is, a state where Te that is insoluble in alkali and TeO₂ that is soluble in alkali are mixed uniformly. However, when TeO₂ existing at the surface of the resist dissolves in alkali due to the alkali development process, Te rapidly appears at the surface so that the solubility of the resist in alkali is relatively low. When the resist of the present invention is melted and crystallized by exposure and heating, Te and TeO₂ cause a phase separation because of low phase solubility. As a result, crystals of Te grow, and TeO₂ is evenly distributed so as to fill gaps among the crystals of Te. Consequently, when the alkali development process is performed, the evenly distributed TeO₂ dissolves, and the crystals of Te that lost their surrounding molecules (TeO₂) also dissolve into the alkali solution. Thus, the resist of the present invention can work as a positive type resist by means of the alkali development process. However, it was found that the following problem remained if a material of only TeOₓ is used as the resist.

In forming an excellent pattern, it is preferable that that the resist has high contrast during development. In other words, it is preferable that the resist have a low solubility in the developing solution at unexposed portions and a high solubility in the developing solution at exposed portions. If these two preferences are interpreted and reworded in a case of using a resist made of TeOₓ, then the following two requirements will be present.

### (First requirement)

It is preferable that a large amount of Te is contained in the composition of the resist so as to decrease the solubility in the developing solution (alkali) of unexposed portions (uncrystallized portions).

### (Second requirement)

It is preferable that an appropriate value of the composition ratio of Te and TeO₂ is present so as to increase the solubility in the developing solution (alkali) at exposed portions (crystallized portions).

However, it was found difficult to satisfy these two requirements at the same time, because the composition ratio of Te that satisfies the first requirement makes the quantity of Te excessive for the second requirement. Therefore, a resist made of only TeOₓ could not realize a good ratio of remaining film or a good line edge roughness.

Accordingly, the present inventors tried to add a material such as Pd, Au or Pt having a lower solubility in alkali to TeOₓ, as a stabilizing additive, so that the stabilizing additive plays a role in decreasing the solubility in alkali at unexposed portions (uncrystallized portions), while setting the composition ratio of Te and TeO₂ at a value that is suitable for increasing the solubility in alkali at exposed portions (crystallized portions). As a result, it was possible to perform development at a high contrast. Thus, a good ratio of remaining film and a good line edge roughness could be realized. The stabilizing additive is only required to have the effect of decreasing the solubility in alkali at the unexposed portions. So, it is thought that any material having lower solubility in alkali than the TeO₂ that is responsible for the solubility in alkali at the unexposed portions can be used as the stabilizing additive.

In a pattern-forming experiment, a resist using Pd as the stabilizing additive was formed as a resist layer having a thickness of 60 nm on a quartz substrate. The result of the ratio of remaining film and the line edge roughness are shown in Table 1.

**[Table 1]**

| Composition ratio of the stabilizing additive | Ratio of Remaining film | Line edge roughness |
|---|---|---|
| 0.00 | 0.13 | Bad |
| 0.05 | 0.31 | Acceptable |
| 0.10 | 0.61 | Acceptable |
| 0.15 | 0.89 | Good |
| 0.20 | 0.92 | Good |
| 0.25 | 0.91 | Good |
| 0.30 | 0.93 | Good |
| 0.35 | 0.95 | Good |
| 0.40 | 0.95 | Good |
| 0.45 | 0.98 | Good |
| 0.50 | 0.99 | Good |
| 0.55 | 0.98 | Good |
| 0.60 | 0.98 | - |
| 0.65 | 0.99 | - |

Note that the composition ratio of the stabilizing additive is expressed by (the number of atoms of the stabilizing additive in the resist)/(the sum of the number of atoms of Te and the number of atoms of the stabilizing additive in the resist).

Of the various conditions of the composition ratio of the stabilizing additive, the composition of O in the resist is chosen to be that when the most preferable pattern was formed (a good result was obtained when x in TeOₓ was within the range of 0.3-1.7). The exposure was performed selectively using a laser having a wavelength of 405 nm, an irradiation intensity on the resist within the range 0.1-2.0 mJ/m and an objective lens having the NA of 0.95, so as to form a series of long and short pits, at a minimum pit length of approximately 100 nm and track pitch of 320 nm, in a spiral. In the development process, of the various conditions of the composition ratio of the stabilizing additive, the concentration value of TMAH was selected when the best pattern was obtained (a good result was obtained at a concentration within the range of 0.02%-20%) .

The ratio of remaining film is expressed by (a film thickness at the unexposed portion after the development) / (a film thickness at the exposed portion after the development).

The line edge roughness is defined by (the maximum value of a pit width)-(the minimum value of a pit width) in a pit that is sufficiently long to be considered a line. The evaluation result of the line edge roughness is shown in three marks "Good, Acceptable and Bad": "Good" indicates a good line edge roughness that is smaller than 20 nm; "Acceptable" indicates an acceptable line edge roughness that is within the range of 20-60 nm; and "Bad" indicates an unacceptable line edge roughness that is more than or equal to 60 nm.

Note that although the exposure in this experiment was performed using a light source having the wavelength 405 nm and irradiation intensity on the resist within the range of 0.1-2.0 mJ/m, the method of the present invention is not limited to these values of wavelength and intensity of light used for exposure. It was confirmed by experiments using a deuterium lamp, semiconductor lasers or gas lasers of various wavelengths for example that the resist of the present invention has sensitivity within the range from 121 nm to 940 nm. In heat-mode recording, exposure light does not directly depend on the wavelength itself, as long as it can raise the temperature. The effects of the present invention can be obtained by using light or radiation rays of any wavelength. In addition, the thickness of the resist layer is not limited to 60 nm, but it was found that a resist layer having a thickness within the range of 5-200 nm can be used without any problem. The thinner the thickness of the resist layer is, the more minute the pattern that can be formed. A pattern size already confirmed by the experiment has a line width of 17 nm and hole diameter of 24 nm. However, there was no evidence of the resolution limit of the resist, so it is thought that a minuter pattern can be formed by optimizing the exposure wavelength and the optical system. Regarding the composition of the resist, it is preferable that an absorption coefficient of the resist is larger if the thickness of the resist layer is small. Therefore, it is good to decrease the quantity of O in the composition of the resist. On the contrary, it is preferable that an absorption coefficient of the resist is smaller if the thickness of the resist layer is large. In this case, it is good to increase the quantity of O in the composition of the resist.

As is clearly understood from Table 1, the effect of increasing the ratio of remaining film can be reliably obtained when the composition ratio of the stabilizing additive is more than or equal to 0.05, and the effect of increasing the ratio of remaining film can be improved even more when the composition ratio of the stabilizing additive is more than or equal to 0.15. In addition, when the composition ratio of the stabilizing additive is more than or equal to 0.05, the line edge roughness is improved. However, when the composition ratio of the stabilizing additive is equal to or more than 0.55, a drop in sensitivity of the resist is observed. When the composition ratio of the stabilizing additive is equal to or more than 0.60, the exposure could not generate crystallization.

According to the experimental results described above, the effect of the present invention can be obtained when the composition ratio of the stabilizing additive is at least within the range of 0.05-0.55, and the effect of the present invention can be increased when it is within the range of 0.15-0.50. However, it is thought that the effect of the present invention can be obtained even if the composition ratio of the stabilizing additive is equal to or more than 0.60 when a drop in sensitivity of the resist is not of concern.

Other than Pd, there are other stabilizing additives that enable the effect of the present invention to be obtained, which include Mg, Si, Ti, V, Cr, Mn, Fe, Co, Ni, Cu, As, Se, Y, Nb, Mo, Tc, Ru, Rh, Pd, Ag, Cd, In, Sb, Ta, W, Pt, Au, Bi, and oxides, nitrides and the like of these elements. Among these, the stabilizing additives that enable an especially high effect of the present invention to be obtained are Pd, Au, Pt, Cu, Sb, Bi, Si, and compounds such as oxides, nitrides and the like of these elements. Each has a low solubility in alkali and is thought to have the effect of decreasing the solubility in alkali at unexposed portions of the resist of the present invention.

### (Embodiment 2)

Next, a method for manufacturing an optical information recording medium by using the resist and the method for forming a pattern of the present invention will be described with reference to more detailed data. Note that, steps previous to manufacturing the master of an optical information recording medium are as described above, and the following description is only an example of the above method. The following description does not limit the range of application of the method of the present invention. A resist of TeOₓPd_{y} was formed to a thickness of 60 nm on a substrate made of quartz glass having diameter 200 mm and thickness 5 mm. The resist was formed by using a target that is a mixture of Te and Pd at the ratio of 74 to 26 and a gas mixture of Ar and O by the reactive sputtering method, so as to make a recording master. Pressure inside the vacuum chamber was 2 mTorr during the sputtering, and partial pressure of O was 0.6 mTorr. Particularly good characteristics could be obtained when x was within the range 0.8-1.4, while y was approximately 26/74.

Using this recording master, a laser having the wavelength 405 nm and an objective lens having NA of 0.95, a series of long and short pits having the minimum pit length of approximately 100 nm was exposed selectively by the recording method that was explained above with reference to Fig. 2. The signal modulation pattern was 1-7 pp, a length of the signal 2T (which was the shortest pit) was set to 149 nm, and the track pitch was set to 320 nm (this corresponds to a 25 GB storage capacity per layer in an optical information recording medium having the diameter 120 mm). Note that a good pattern could be formed by using a resist layer having the same composition and the same thickness and by setting the physically minimum pit length to 50 nm and the track pitch to 100 nm. Note that there is no limit to the thickness of the resist for forming larger pattern as long as the exposure apparatus permits. Of course, if the thickness of the resist layer is decreased, a minuter pattern can be formed.

Next, development is performed for 60 seconds using 2.4% TMAH, so as to make a master of an optical information recording medium having a pattern of lands and pits with a height of 55 nm. It was found that a concentration of TMAH within the range of 0.2%-4.0% did not cause any change in the pattern of pits and lands on the master or in the ratio of remaining film, and that the resist of the present invention has a very large development margin compared with the conventional resist. In addition, in another resist of the present invention having a different composition, for a range of concentration of the developing solution which has the same development effects, the maximum value of the range was approximately ten times the minimum value. Note that the absolute value of the concentration can be different from that described above. Also, for a range of development times in which the development result did not change, the maximum value of the range was more than two times the minimum value. Furthermore, with respect to the environmental resistance of the resist of the present invention, it has excellent characteristics, and the development process is not affected after exposure to sunlight or storage in the atmosphere at an ambient temperature for six months.

The method for manufacturing an optical information recording medium from a master that was made as described above is a conventional technique, so it will be described only briefly below. A metal layer is formed on the master by plating Ni or the like, and the metal layer removed from the master is processed and shaped so as to manufacture a stamper. Using an injection molding technique, the pattern of pits and lands of this stamper is transferred to a disk substrate that is made of polycarbonate and has diameter 120 mm and thickness 1.1 mm. Note that other resins such as acrylic resin can be used as the material of the disk substrate, and the diameter and the thickness of the disk substrate can be any value. Furthermore, using a sputtering method or vapor deposition method, a reflection film made of Ag is formed on the pattern of pits and lands of this disk substrate. Then, an ultraviolet curing resin is applied to the reflection film by a spin coat method, and the resin is cured by ultraviolet rays, forming a protection layer having a thickness of 0.1 mm, completing the manufacture of the optical information recording medium. Note that a material such as Au, Al or Si that has a high reflectivity can be used for the reflection film, and resin sheets made of polycarbonate or acrylic resin can be bonded together via an adhesive sheet for the protection layer. In addition, if signal reproduction is performed from the opposite side to the protection layer, an opaque material can be used for the protection layer.

The optical information recording medium manufactured in this way was evaluated on the jitter of reproduced signals by using reproduction light having a wavelength of 405 nm and an objective lens having NA of 0.85. As a result of the evaluation, a very good signal characteristic was obtained, which was 5.7% when using a limit equalizer. It is understood that if the jitter value of the reproduced signal under the above-mentioned conditions is 6.5% or less, it is sufficiently small for practical use.

### (Other embodiments)

Note that, although an optical information recording medium of a read-only type is exemplified in the above description of the manufacturing method, the method of the present invention can also be applied to a method for manufacturing a recordable type optical information recording medium. In this case, instead of the above-mentioned series of long and short pits, a guide groove may be selectively exposed, and a recording layer made of a phase change material may be formed in addition to the above-mentioned reflection layer. However, the method for manufacturing an optical information recording medium according to the present invention has maximum effect when forming a pattern by using the resist of the present invention. As long as a pattern of pits and lands formed by the method of the present invention is transferred directly or indirectly onto the optical information recording medium, any structures and any elements of the reflection layer and the recording layer of the optical information recording medium can be adopted. In addition, the formation of a guide groove pattern is easier than the formation of a pattern of pits having the same width. Therefore, if the method for manufacturing a master of an optical information recording medium (which was described by exemplifying a read-only type medium) is used, a master having higher density can be produced, and then an optical information recording medium can also be produced.

The resist, the method for forming a pattern and the method for manufacturing a master of an optical information recording medium according to the present invention have the effects that a minuter pattern can be formed than the photon-mode recording method using a light source of the same wavelength, and that a high environmental resistance can be obtained. The present invention is useful for micromachining processes in the order of nanometers, such as manufacturing of an optical information recording medium, a semiconductor device, a display panel or a micro machine.

## Claims

1. A method of manufacturing a master of an optical information recording medium, the method comprising:
a resist layer formation step of using a resist to form a resist layer on an upper surface of a substrate;
an exposure step for selectively exposing the resist layer to cause a change of state in the resist layer; and
a development step for performing an alkali development process on the resist layer after the exposure step, wherein
the resist is primarily composed of an inorganic material which contains at least Te, O and a stabilizing additive having a lower solubility than TeO₂ in an alkaline environment.

2. The method according to claim 1, wherein the combination of Te and O in the resist is expressed by the composition formula TeOₓ, where 0.3 ≦ x ≦ 1.7.

3. The method according to claim 2, wherein the combination of Te and O in the resist is expressed by the composition formula TeOₓ, where 0.8 ≦ x ≦ 1.4.

4. The method according to any one of claims 1-3, wherein the stabilizing additive of the resist contains at least one material selected from the group consisting of Mg, Si, Ti, V, Cr, Mn, Fe, Co, Ni, Cu, As, Se, Y, Nb, Mo, Tc, Ru, Rh, Pd, Ag, Cd, In, Sb, Ta, W, Pt, Au, Bi and a combination of these elements.

5. The method according to claim 4, wherein the stabilizing additive of the resist contains at least one material selected from the group consisting of Pd, Au, Pt, Cu, Sb, Bi, Si and a combination of these elements.

6. The method according to claim 4 or 5, wherein the composition ratio of the stabilizing additive is within the range of 0.05-0.55.

7. The method according to claim 6, wherein the composition ratio of the stabilizing additive is within the range of 0.15-0.50.

8. The method according to any one of claims 1-7, wherein, in the resist layer formation step, the resist layer is formed by a vacuum process.

9. The method according to claim 8, wherein, in the resist layer formation step, the vacuum process utilizes a sputtering method.

10. The method according to any one of claims 1-9, wherein, in the development step, the alkali development process utilizes a developing solution that contains TMAH.

11. A master of an optical information recording medium, wherein the master is manufactured by the method according to any one of claims 1-10.

12. A stamper that is manufactured by using the master according to claim 11.

13. An optical information recording medium that is manufactured by using the stamper according to claim 12.

14. A resist comprising an inorganic material which contains at least Te, O and a stabilizing additive having a lower solubility than TeO₂ in an alkaline environment.

15. The resist according to claim 13, wherein the combination of Te and O is expressed by the composition formula TeOₓ, where 0.3 ≦ x ≦ 1.7.

16. The resist according to claim 15, wherein the combination of Te and O is expressed by the composition formula TeOₓ, where 0.8 ≦ x ≦ 1.4.

17. The resist according to any one of claims 14-16, wherein the stabilizing additive contains at least one material selected from the group consisting of Mg, Si, Ti, V, Cr, Mn, Fe, Co, Ni, Cu, As, Se, Y, Nb, Mo, Tc, Ru, Rh, Pd, Ag, Cd, In, Sb, Ta, W, Pt, Au, Bi and a combination of these elements.

18. The resist according to claim 17, wherein the stabilizing additive contains at least one material selected from the group consisting of Pd, Au, Pt, Cu, Sb, Bi, Si and a combination of these elements.

19. The resist according to claim 17 or 18, wherein the composition ratio of the stabilizing additive is within the range of 0.05-0.55.

20. The resist according to claim 19, wherein the composition ratio of the stabilizing additive is within the range of 0.15-0.50.

21. A method of forming a pattern, comprising:
a resist layer formation step of using a resist according to any one of claims 14-20 to form a resist layer on an upper surface of a substrate;
an exposure step for selectively exposing the resist layer to cause a change of state in the resist layer; and
a development step for performing an alkali development process on the resist layer after the exposure step.

22. The method according to claim 2, wherein the composition ratio of TeOx is within the range of 0.45-0.95.

## Patentansprüche

1. Verfahren zum Herstellen eines Masters eines optischen Informationsaufzeichnungsmediums, mit den Schritten:
Resist-Schicht-Bildungsschritt des Verwendens eines Resists zum Bilden einer Resist-Schicht auf einer oberen Oberfläche eines Substrats,
Belichtungsschritt zum ausgewählten Belichten der Resist-Schicht zum Verursachen einer Zustandsänderung in der Resist-Schicht, und
Entwicklungsschritt zum Durchführen eines Alkali-Entwicklungs-Prozesses an der Resist-Schicht nach dem Belichtungsschritt, wobei
das Resist vornehmlich aus einem inorganischen Material besteht, das zumindest Te, O und ein stabilisierendes Additiv enthält, das eine geringere Löslichkeit als TeO₂ in einer basischen Umgebung besitzt.

2. Verfahren nach Anspruch 1, wobei die Kombination von Te und O in dem Resist durch die Verbindungsformel TeOₓ ausgedrückt ist, wobei 0,3 ≤x ≤1,7.

3. Verfahren nach Anspruch 2, wobei die Kombination von Te und O in dem Resist durch die Verbindungsformel TeOₓ ausgedrückt ist, wobei 0,8 ≤x ≤1,4.

4. Verfahren nach einem der Ansprüche 1 bis 3, wobei das stabilisierende Additiv des Resists zumindest ein Material enthält, das ausgewählt ist aus der Gruppe bestehend aus Mg, Si, Ti, V, Cr, Mn, Fe, Co, Ni, Cu, As, Se, Y, Nb, Mo, Tc, Ru, Rh, Pd, Ag, Cd, In, Sb, Ta, W, Pt, Au, Bi und einer Kombination dieser Elemente.

5. Verfahren nach Anspruch 4, wobei das stabilisierende Additiv des Resists zumindest ein Material aufweist, das ausgewählt ist aus der Gruppe bestehend aus Pd, Au, Pt, Cu, Sb, Bi, Si und einer Kombination dieser Elemente.

6. Verfahren nach Anspruch 4 oder 5, wobei das Mischungsverhältnis des stabilisierenden Additivs innerhalb des Bereichs von 0,05 bis 0,55 liegt.

7. Verfahren nach Anspruch 6, wobei das Mischungsverhältnis des stabilisierenden Additivs innerhalb des Bereichs von 0,15 bis 0,50 liegt.

8. Verfahren nach einem Ansprüche 1 bis 7, wobei die Resist-Schicht in dem Resist-Schicht-Bildungsschritt durch ein Vakuumverfahren gebildet wird.

9. Verfahren nach Anspruch 8, wobei das Vakuumverfahren in dem Resist-Schicht-Bildungsschritt ein Sputter-Verfahren verwendet.

10. Verfahren nach einem der Ansprüche 1 bis 9, wobei in dem Entwicklungsschritt der Alkali-Entwicklungs-Prozess eine Entwicklungslösung verwendet, die TMAH enthält.

11. Master eines optischen Informationsaufzeichnungsmediums, wobei der Master mit einem Verfahren gemäß einem der Ansprüche 1 bis 10 hergestellt ist.

12. Stempel, der unter Verwendung eines Masters gemäß Anspruch 11 hergestellt ist.

13. Optisches Informationsaufzeichnungsmedium, das unter Verwendung eines Stempels gemäß Anspruch 12 hergestellt ist.

14. Resist mit einem anorganischen Material, das zumindest Te, O und ein stabilisierendes Additiv enthält, das eine geringere Löslichkeit als TeO₂ in einer basischen Umgebung besitzt.

15. Resist nach Anspruch 13, wobei die Kombination von Te und O durch die Verbindungsformel TeOₓ ausgedrückt ist, wobei 0,3 ≤x ≤1,7.

16. Resist nach Anspruch 15, wobei die Kombination von Te und O durch die Verbindungsformel TeOₓ ausgedrückt ist, wobei 0,8 ≤x ≤1,4.

17. Resist nach einem der Ansprüche 14 bis 16, wobei das stabilisierende Additiv zumindest ein Material aufweist, das ausgewählt ist aus der Gruppe bestehend aus Mg, Si, Ti, V, Cr, Mn, Fe, Co, Ni, Cu, As, Se, Y, Nb, Mo, Tc, Ru, Rh, Pd, Ag, Cd, In, Sb, Ta, W, Pt, Au, Bi und einer Kombination dieser Elemente.

18. Resist nach Anspruch 17, wobei das stabilisierende Additiv zumindest ein Material aufweist, das ausgewählt ist aus der Gruppe bestehend aus Pd, Au, Pt, Cu, Sb, Bi, Si und einer Kombination dieser Elemente.

19. Resist nach Anspruch 17 oder 18, wobei das Mischungsverhältnis des stabilisierenden Additivs innerhalb des Bereichs von 0,05 bis 0,55 liegt.

20. Resist nach Anspruch 19, wobei das Mischungsverhältnis des stabilisierenden Additivs innerhalb des Bereichs von 0,15 bis 0,50 liegt.

21. Verfahren zum Bilden eines Musters, mit:
einem Resist-Schicht-Bildungsschritt des Verwendens eines Resists nach einem der Ansprüche 14 bis 20 zum Bilden einer Resist-Schicht auf einer oberen Oberfläche eines Substrats,
einem Belichtungsschritt zum ausgewählten Belichten der Resist-Schicht zum Verursachen einer Zustandsänderung in der Resist-Schicht, und
einem Entwicklungsschritt zum Durchführen eines Alkali-Entwicklungs-Prozesses an der Resist-Schicht nach dem Belichtungsschritt.

22. Verfahren nach Anspruch 2, wobei das Mischungsverhältnis von TeOₓ innerhalb des Bereichs von 0,45 bis 0,95 liegt.

## Revendications

1. Procédé pour fabriquer un disque maître destiné à la fabrication d'un support d'enregistrement optique d'informations, le procédé comprenant :
une étape de formation d'une couche de réserve consistant à utiliser une réserve pour former une couche de réserve sur une surface supérieure d'un substrat ;
une étape d'exposition pour exposer de manière sélective la couche de réserve de façon à provoquer un changement dans l'état de la couche de réserve ; et
une étape de développement consistant à accomplir un processus de développement à l'alcali sur la couche de réserve après l'étape d'exposition, dans lequel :
la réserve est composée principalement d'un matériau inorganique qui contient au moins Te, O et un additif de stabilisation ayant une solubilité moins élevée que TeO₂ dans un environnement alcalin.

2. Procédé selon la revendication 1, dans lequel la combinaison de Te et O dans la réserve est exprimée par la formule de composition TeOₓ, dans laquelle 0,3 ≤ x ≤ 1,7.

3. Procédé selon la revendication 2, dans lequel la combinaison de Te et O dans la réserve est exprimée par la formule de composition TeOₓ, dans laquelle 0,8 ≤ x ≤ 1,4.

4. Procédé selon l'une quelconque des revendications 1 à 3, dans lequel l'additif de stabilisation de la réserve contient au moins un matériau sélectionné à partir du groupe composé de : Mg, Si, Ti, V, Cr, Mn, Fe, Co, Ni, Cu, As, Se, Y, Nb, Mo, Tc, Ru, Rh, Pd, Ag, Cd, In, Sb, Ta, W, Pt, Au, Bi, et une combinaison de ces éléments.

5. Procédé selon la revendication 4, dans lequel l'additif de stabilisation de la réserve contient au moins un matériau sélectionné à partir du groupe composé de : Pd, Au, Pt, Cu, Sb, Bi, Si, et une combinaison de ces éléments.

6. Procédé selon la revendication 4 ou 5, dans lequel le rapport de composition de l'additif de stabilisation se situe à l'intérieur de la plage de 0,05 à 0,55.

7. Procédé selon la revendication 6, dans lequel le rapport de composition de l'additif de stabilisation se situe à l'intérieur de la plage de 0,15 à 0,50.

8. Procédé selon l'une quelconque des revendications 1 à 7, dans lequel, au cours de l'étape de formation de la couche de réserve, la couche de réserve est formée au moyen d'un traitement sous vide.

9. Procédé selon la revendication 8, dans lequel, au cours de l'étape de formation de la couche de réserve, le traitement sous vide utilise un procédé de pulvérisation.

10. Procédé selon l'une quelconque des revendications 1 à 9, dans lequel, au cours de l'étape de développement, le processus de développement à l'alcali utilise une solution de développement qui contient TMAH.

11. Disque maître destiné à la fabrication d'un support d'enregistrement optique d'informations, dans lequel le disque maître est fabriqué en réalisant le procédé selon l'une quelconque des revendications 1 à 10.

12. Matrice de pressage qui est fabriquée en utilisant le disque maître selon la revendication 11.

13. Support d'enregistrement optique d'informations qui est fabriqué en utilisant la matrice de pressage selon la revendication 12.

14. Réserve comprenant un matériau inorganique qui contient au moins Te, O et un additif de stabilisation ayant une solubilité moins élevée que TeO₂ dans un environnement alcalin.

15. Réserve selon la revendication 13, dans laquelle la combinaison de Te et O est exprimée par la formule de composition TeOₓ, dans laquelle 0,3 ≤ x ≤ 1,7.

16. Réserve selon la revendication 15, dans laquelle la combinaison de Te et O est exprimée par la formule de composition TeOₓ, dans laquelle 0,8 ≤ x ≤ 1,4.

17. Réserve selon l'une quelconque des revendications 14 à 16, dans laquelle l'additif de stabilisation de la réserve contient au moins un matériau sélectionné à partir du groupe composé de : Mg, Si, Ti, V, Cr, Mn, Fe, Co, Ni, Cu, As, Se, Y, Nb, Mo, Tc, Ru, Rh, Pd, Ag, Cd, In, Sb, Ta, W, Pt, Au, Bi, et une combinaison de ces éléments.

18. Réserve selon la revendication 17, dans laquelle l'additif de stabilisation de la réserve contient au moins un matériau sélectionné à partir du groupe composé de : Pd, Au, Pt, Cu, Sb, Bi, Si, et une combinaison de ces éléments.

19. Réserve selon la revendication 17 ou 18, dans laquelle le rapport de composition de l'additif de stabilisation se situe à l'intérieur de la plage de 0,05 à 0,55.

20. Réserve selon la revendication 19, dans laquelle le rapport de composition de l'additif de stabilisation se situe à l'intérieur de la plage de 0,15 à 0,50.

21. Procédé de formation d'un motif, comprenant :
une étape de formation d'une couche de réserve consistant à utiliser une réserve selon l'une quelconque des revendications 14 à 20, pour former une couche de réserve sur une surface supérieure d'un substrat ;
une étape d'exposition pour exposer de manière sélective la couche de réserve de façon à provoquer un changement dans l'état de la couche de réserve ; et
une étape de développement consistant à accomplir un processus de développement à l'alcali sur la couche de réserve après l'étape d'exposition.

22. Procédé selon la revendication 2, dans lequel le rapport de composition de TeOₓ se situe à l'intérieur de la plage de 0,45 à 0,95.
